Europäisches Patentamt

**European Patent Office**

Office européen des brevets

(11) Publication number: **0 018 736**
**A1**

(12) # EUROPEAN PATENT APPLICATION

(21) Application number: **80301158.4**

(22) Date of filing: **10.04.80**

(51) Int. Cl.³: **G 06 F 11/26**

(30) Priority: **01.05.79 US 35041**

(43) Date of publication of application:
**12.11.80 Bulletin 80/23**

(84) Designated Contracting States:
**DE FR GB**

(71) Applicant: **MOTOROLA, INC.**
**1303 East Algonquin Road**
**Schaumburg Illinois 60196(US)**

(72) Inventor: **Daniels, Richard Gary**
**9005 Charnwood**
**Round Rock, Texas 78664(US)**

(72) Inventor: **Rupp, II, Edward Jacob**
**2000 Burton Drive Apartment 202**
**Austin, Texas 78741(US)**

(72) Inventor: **Boney, Joel Fredrick**
**6707 La Salle Drive**
**Austin, Texas 78723(US)**

(72) Inventor: **Thomas, James Stanley**
**Route 2 Box 76D**
**Manor, Texas 78653(US)**

(74) Representative: **Newens, Leonard Eric et al,**
**F.J. CLEVELAND CO. 40/43 Chancery Lane**
**London WC2A 1JQ(GB)**

(54) **Self-testing microcomputer and method of testing.**

(57) A microcomputer comprising read-out-memory (120) (ROM) for storing a control program and a processor (100) for executing the control program, the control program including a series of instructions designed and arranged within the memory for functionally testing the microcomputer operative elements such as the ROM, random-access-memory (RAM) (110), input-output (140, 150, 160) ports, arithmetic and logic unit (28), timer (131), and interrupt structure by executing the instructions upon gaining access thereto by a vector selection mechanism.

./...

Fig.1

Fig.2

"SELF-TESTING MICROCOMPUTER"

## Related Applications

(1)  U.S. Serial No. 035,138 filed 1st May 1979, of
Boney et al entitled "Microcomputer With Branch On Bit
Set/Clear Instruction" and assigned to the assignee of the
present invention.

## Technical Field

This invention relates to the testing of complex logic
circuits, and more specifically to a microcomputer which is
capable of testing the functionality of itself.

## Background and Prior Art

Modern semiconductor processing techniques allow the
inclusion of large numbers of individual transistors,
resistors, capacitors and the like on a single piece of
substrate material.  Complex circuits and functions such as
microcomputers may have tens of thousands of transistors on
a single square of silicon less than a quarter-inch on a
side.  Advances in design and processing have also driven
the cost of producing a silicon chip downward, while
complexity has increased.  The cost of testing and
assembling such devices has been relatively constant in
terms of device complexity.  Therefore, as a function of
product cost, testing occupies an increasingly large
percentage.

For ease of processing, hundreds of VLSI (very large
scale integration) devices (dice) are made on 4 inch
diameter wafers of silicon (each die is one unpackaged VLSI
device).  Since assembly costs are high, each die is
usually tested while still on the wafer in order to
determine which dice are good enough to be worth packaging.

This testing is done using a tester connected to a "probe" that has a movable head with tiny needles that make contact with the bonding pads on the die. The prober steps from die to die on the wafer testing each device and marking each bad die with a spot of ink. The wafer is then sawed into individual dice and the good dice are assembled into packages. The finished parts are tested again before being shipped to customers (final test). In most cases the probe test is an "easy functional" test that is intended to weed out most of the bad parts; but not necessarily all bad parts. The test programmer will strive to make the probe test as fast as possible to increase thruput while achieving high final test yield.

In both probe and final test, the test equipment may be connected to a complex computer system that executes a test program and verifies the results. These testers can cost 1/2 million dollars or more. This large capital investment must be amortized of course, and this can amount to several cents per part. Quite often large testers are being used to test a VLSI part which has as much or more computational capability than the tester.

Designing a VLSI part with test circuitry on it may reduce the burden on external test equipment and thus reduce the complexity and cost of the test equipment. Furthermore, if certain test features were included on the VLSI device, they may be made available for use by customers of the device for incoming inspection or the like.

Summary of the Invention

Accordingly, it is an object of the instant invention to provide a microcomputer capable of performing functional tests upon itself at the time of manufacture and thereafter.

It is a further object of the invention to provide a method for the self-testing of microcomputer, microprocessor, or other large scale integration devices.

These and other objects of the invention are achieved in accordance with a preferred embodiment of the invention by providing a microcomputer comprising a read-only-memory for storing a control program and a processor for executing the control program, the control program including a series of instructions designed and arranged within the memory for functionally testing the microcomputer operative elements such as the read-only-memory, random access memory, input-output ports, arithmetic and logic unit and interrupt structure, by executing the instructions

-4-

upon gaining access thereto by a vector selection mechanism.

The ROM contains space for a user control program and also allocates space for a resident self-test program which is entered by causing interrupts and RESET to be vectored to locations other than the normal user locations when one of the pins is held at a higher than normal voltage (i.e. a self-test mode is entered). Thus the self-test program is executed rather than the user program. Further the location itself of the self-test program in the ROM contributes to self-testing of the ROM by testing for shorts and opens in rows and columns of the ROM.

Brief Description of the Drawings

FIG. 1 is a block diagram of a preferred embodiment of the microcomputer in which the present invention is embodied.

FIG. 2 shows a block diagram of the processor of the microcomputer shown in FIG. 1.

FIG. 3 is an external diagram, with connecting pins identified, of a microcomputer connected in a self-test configuration.

FIGS. 4A, 4B and 4C taken together show detailed logic used to enable self-test mode.

FIG. 5 shows the layout of FIGURES 4A, 4B and 4C.

FIG. 6 shows the stack pointer stacking order of the processor of FIG. 2.

### Detailed Description of a Preferred Embodiment

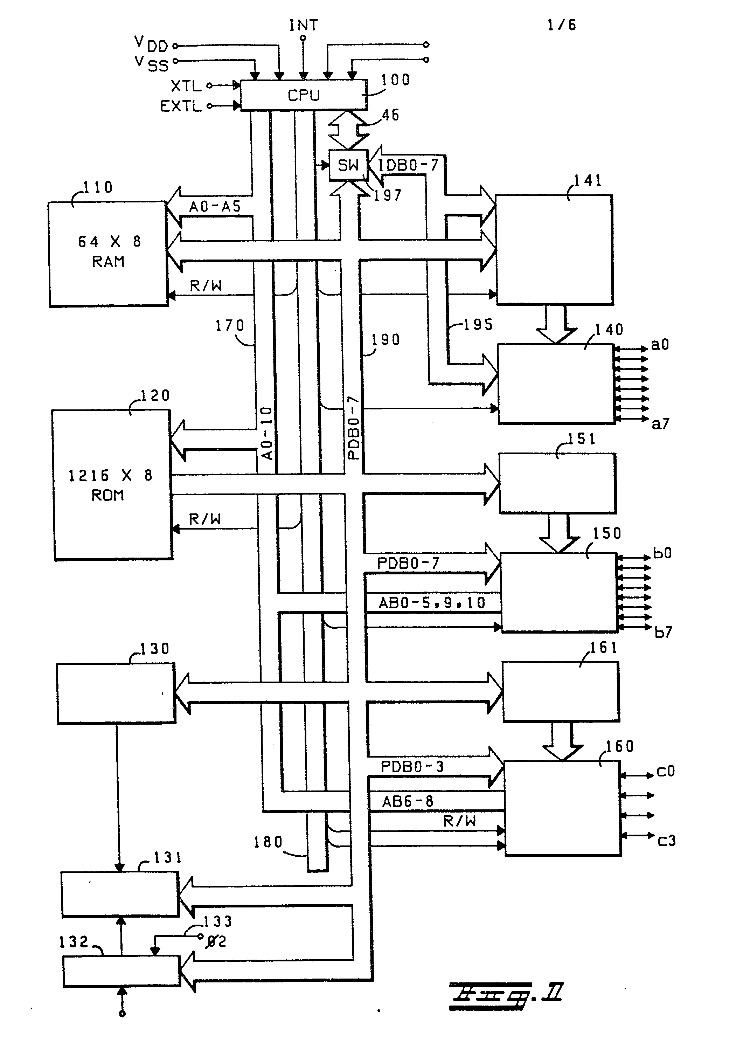

With reference to FIG. 1 a block diagram of the single-chip microcomputer embodying the present invention is shown. It will be understood that the ·present invention may be implemented in other than a single-chip microcomputer. The microcomputer shown in FIG. 1 represents the Motorola MC6805 microcomputer.

The microcomputer shown in FIG. 1 comprises a central processor unit (CPU) 100, a random access memory (RAM) 110, a read only memory (ROM) 120, a timer control register 130, a timer counter 131, a timer prescaler 132, three I/O ports 140, 150 and 160, and associated data direction logic 141, 151, and 161, respectively, as the major functional blocks. The microcomputer shown in FIG. 1 also comprises an address bus 170, a control bus 180, a peripheral data bus (PDB) 190, and an internal data bus (IDB) 195. CPU 100 receives as inputs thereto an interrupt request signal (INF), a reset ($\overline{RESET}$) signal, a test (TEST) signal, a power supply signal ($V_{CC}$), a ground signal ($V_{SS}$), and a connection to external clock-generating circuitry through the XTL and BXTL inputs.

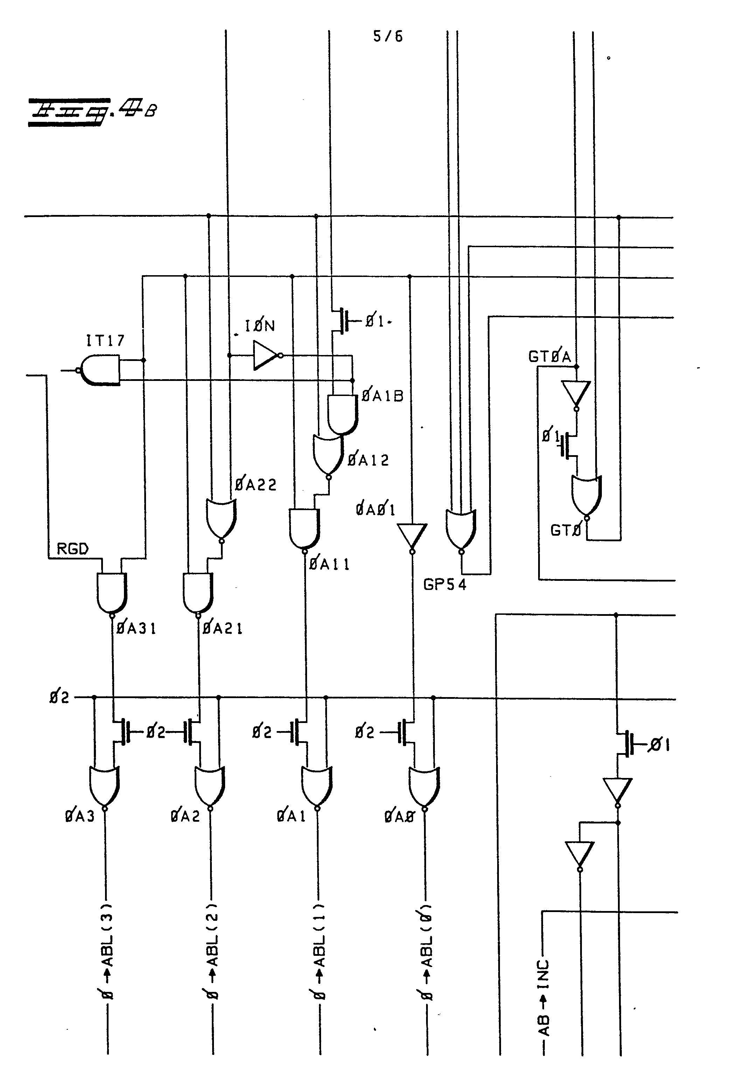

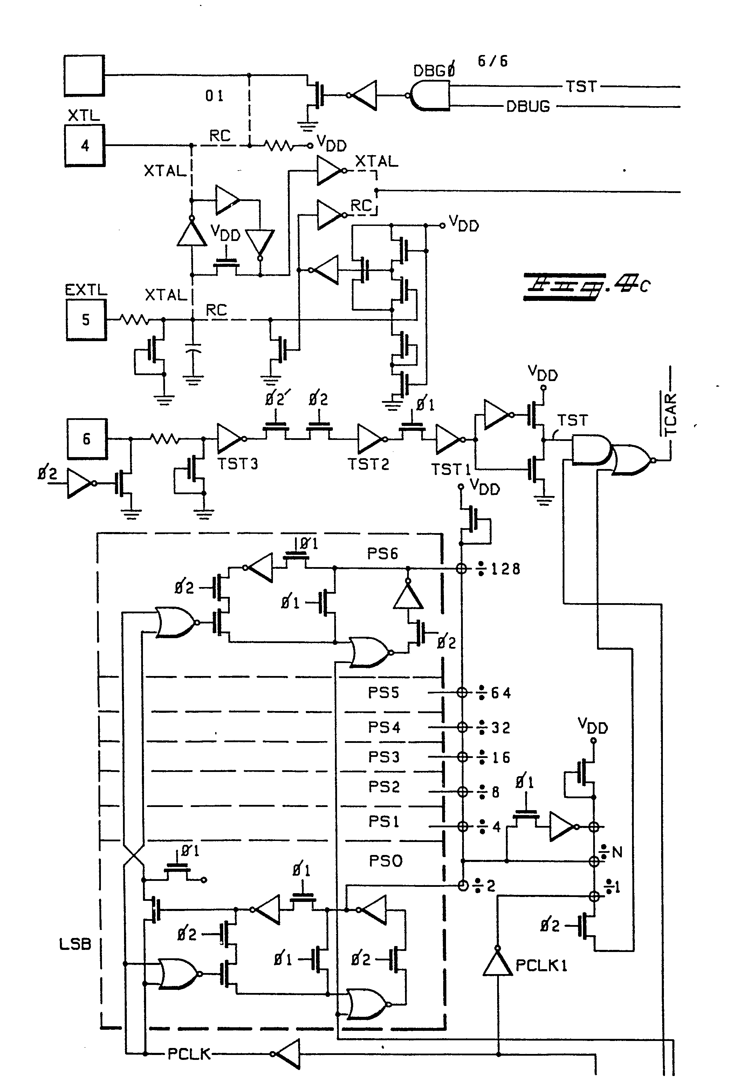

CPU 100 is connected with the other major functional blocks of the microcomputer of FIG. 1 by means of address bus 170, control bus 180, peripheral data bus 190, and internal data bus 195. As will be discussed further below, in the test mode CPU 100 is disconnected from peripheral data bus 190 by means of switch (SW) 197, and data and instructions are received by CPU 100 solely through port A via internal data bus 195. It will be understood that the block diagram of the microcomputer shown in FIG. 1 illustrates only the salient architectural features and reference should be made to the detailed logic diagram of FIGS. 7A-7EEE of the above-noted application for the detailed implementation of the major functional blocks and their interconnections.

Ports A and B are 8-bit ports, and port C is a 4-bit port. Port A has 1/0 lines a∅-a7; port B has 1/0 lines b∅-b7; and port C has 1/0 lines c∅-c3. Each of the 1/0 lines of each port is programmable as either an input or output depending upon the information written into the data direction logic 141, 151, and 161 associated with the respective ports A-C. As will be discussed in further detail below, in the test mode the lines of Port B become multiplexed, carrying data when clock Ø2 is high and carrying addresses when Ø2 is low. Also when clock Ø2 is low in the test mode, the lines of port C become address lines and the read/write (R/W) line.

In the present preferred embodiment of the microcomputer shown in FIG. 1, the random access memory 110 is capable of storing 64 8-bit bytes of information. The read only memory 120 is capable of storing 1216 8-bit bytes of information of which 1100 are available to the user.

A timer prescaler 132 receives the timer input. The microcomputer of the present invention is available in several different mask options. In a first mask option the timer counter 131 is clocked by an internally generated Ø2 clock over line 133, and the TIMER signal is used for enabling or disabling the timer counter 131. In a second mask option the TIMER input is the clock source for the timer counter 131. Additional mask options determine whether the clock source is connected directly to the timer counter 131 or is initially scaled down through the prescaler 132

-8-

by mask-determinable values between 2 and 128 in $2^n$ increments, where n=1,2,....7.

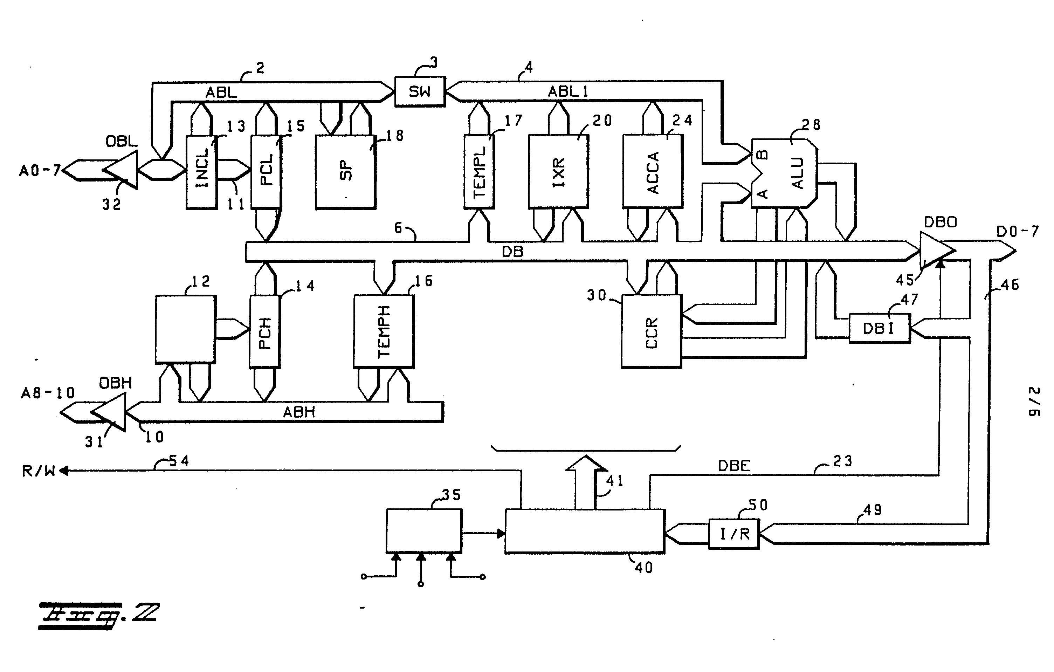

Processor Architecture With reference now to FIG. 2, a block diagram of the processor portion of the microcomputer embodying the present invention is shown. FIG. 2 illustrates the general architecture of the processor and defines the structural and functional relationships between the various registers, address buses, data buses, the arithmetic logic unit (ALU), and other internal logic elements used to control the transfer of digital information within the processor.

The processor includes INCL 13, the 8-bit low-order incrementor register; PCL 15, the 8-bit low-order program counter; SP 18, the 5-bit stack pointer register; TEMPL 17, the 8-bit low-order temporary register; IXR 20, the 8-bit index register; and ACCA 24, the 8-bit accumulator register. The processor also includes INCR 12, the 3-bit high-order incrementor register; PCM 14, the 3-bit high-order pgoram counter; TEMPE 16, the 3-bit high order temporary register; and CCR 30, the 5-bit condition code register.

INCH 12 and INCL 13 form the 11-bit incrementor INC which updates the current program address contained in the 11-bit program counter PC comprising PCH 14 and PCL 15 by incrementing or decrementing its contents. Incrementor INC may also function as an auxiliary register or as an up-down counter or incrementor/decrementor of other registers connected to the address or data buses.

The 11-bit temporary register TEMP comprises TEMPH 16 and TEMPL 17 for temporarily storing digital information within the processor. The stack pointer SP 18 contains the address of the next available location in a push-down/pop-up stack in the RAM 110 (FIG. 1). The 8-bit index register IXR 20 stores digital information utilised in the indexed modes of memory addressing.

Accumulator ACCA 24 is an 8-bit register. The processor also comprises an arithmetic logic unit (ALU) 28 having an A input coupled to data bus 6 and a B input coupled to ABL1 bus 4. ALU 28 generates an output to DB bus 6.

The condition code register CCR 30 is coupled to the ALU 28 as well as to DB bus 6 for temporarily storing various conditions generated by an ALU operation such as carry-borrow (C), result equal to zero (Z), result negative (R), interrupt mask (I), and a half-carry from the least significant four bits of the

The processor includes a first low-order address bus (ABL) 2, a second low-order address bus (ABL1) 4, and a high-order address bus (ABH) 10 in addition to data bus (DB) 6. Switch SW 3 separates ABL 2 and ABL1 4. The low-order address bus ABL 2 drives output buffers designated generally by OBL 32, which in turn drive eight address bus output lines A0-A7, which form a part of the microcomputer address bus 170 (FIG. 1). The high-order address bus ABH 10 drives a plurality of high-order output buffers OBH 31, which in turn drive address bus output lines A8-10 which also form a part of the microcomputer address bus 170 (FIG. 1).

Processor data bus 46 comprises eight data lines D0-7 driven by data bus out (DBO) buffers 45 and sensed by data bus in (DB1) buffers 47. Data bus 46 is used for transferring data between the processor and the other major functional blocks of the microcomputer shown in FIG. 1. In the test mode, data bus 46 transfers data only between the processor and external processing equipment through port A. DBIR 49 is responsive to data bus 46 for temporarily latching an instruction op code for presentation to instruction register I/R 50. I/R 50 holds the instruction op code which is decoded by Decode And Control Logic 40 during an instruction cycle. Decode And Control Logic 40 generates, with appropriate timing, a plurality of control signals over control lines indicated generally as Register And ALU Control Lines 41 to control the transfer of data between the various registers, buses, and the ALU in accordance with the particular instruction op code contained within the I/R 50. DPO 45 is enabled by a DBE signal over control line 33 from the Decode And Control Logic 40.

I/O Logic 35 is responsive to external signals in the form of $\overline{\text{RESET}}$, INT and TBST and generates control signals to Decode And Control Logic 40.

The Decode And Control Logic 40 generates a read/write signal (R/W) over line 54, which line may be considered part of the control bus 160 shown in FIG. 1. The R/W signal is used within the microcomputer to write information into or read information from the major functional blocks shown in FIG. 1.

A more detailed description of the internal operation of the microcomputer may be found in the U.S. patent application noted above, the contents of which are hereby incorporated by reference thereto.

Chip Pin-Cut

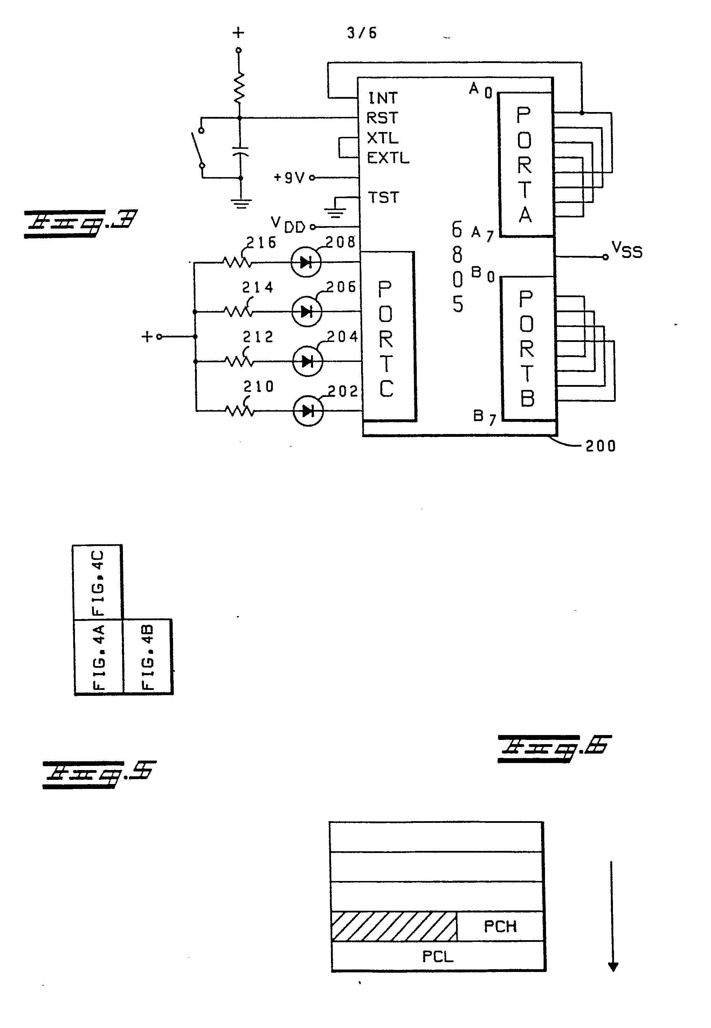

FIG. 3 provides a schematic representation 200 of the pin-out arrangement of the microcomputer of FIG. 1, shown with external connections relevant to operating the device in self-test mode.   The function of each of the pins is as follows:

Power is supplied to the microcomputer via the $V_{SS}$ and $V_{DD}$ Pins.   $V_{DD}$ is nominally +5.0V, and $V_{SS}$ is ground.

The XTL and MXTL pins are provided for clocking the microcomputer.   They may be connected to a crystal or to an external resistor.   Internal divide-by-four circuitry is provided to allow the use of the inexpensive 3.58 MHz color TV crystal for 895 XHz operation. The maximum recommended external crystal frequency for the preferred embodiment of the microcomputer is MHz.   A mask option is provided in  order to match the internal clock oscillator with the selected external component.

The $\overline{RESET}$ signal is provided for a means of externally resetting the microcomputer.   On reset, the stack pointer SP, the timer control register, and the timer counter are initialised, and all I/C lines are set as inputs.

-13-

The microcomputer has 20 I/O pins, each of which may be programmed as an input or an output. Port A has eight I/O lines a0-a7. Port B has eight I/O lines b0-b7. Port C has four I/O lines c0-c3. Port B I/C lines b0-b7, when programmed as outputs, are capable of sinking 10 ma on each pin. All I/O lines are TTL compatible both as inputs and outputs. In addition port A is output compatible with CMOS, and port C is input compatible with CMOS. The state of latence output data is correctly readable as input data regardless of the logic level of the I/O pins due to output loading.

As mentioned above regarding the $\overline{\text{RESET}}$ input, the data direction logic (FIG. 1) associated with ports A-C is cleared (i.e. set to zero) at power-up/reset time which configures all of the I/O lines as inputs. The user-supplied reset routine then configures the I/O lines either as inputs or outputs by loading the data direction logic from the CPU 100 over PDB 190. Programming a zero into the data direction logic associated with a particular I/O line designates such line as an input, whereas programming a one designates such line as an output.

-14-

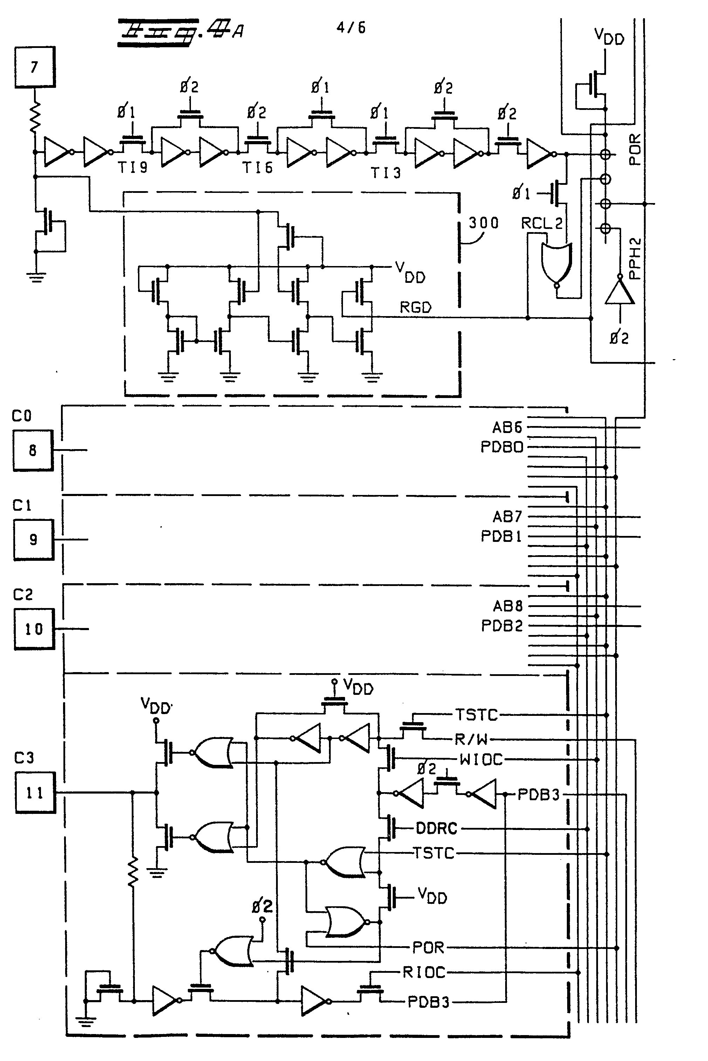

The external interrupt INT is a maskable input signal.  INT is edge-sensitive and internally sets an INT request when there is a negative transition on the INT input pin.  When the interrupt mask bit in the CCR is set, the INT signal is latched until the mask bit is cleared.  An interrupt request results in a hardware controlled sequence at the completion of the instruction currently being executed, in which the current contents of PCL, PCR, IMR, ACCA, and CCR are stacked in the RAM 110.  The stacking order is depleted in FIG. 6.  After stacking is completed, the I bit in the CCR is set, and a vectored interrupt service routine is performed.  Upon the conlusion of the inteerupt service routine, the contents of the CCR, ACCA, IMR, PCH and PCL are restored from the stack.

The INT pin also provides a hardware controlled interrupt service for zero-crossing detection of a 60 Hz AC input.  An interrupt is generated for each negative-slope zero-crossing of the AC signal, which interrupt can be used to service time-of-day software.

The TEST input pin, when set high, configures the I/O lines of ports B and C to carry multiplexed address and data information, depending upon the
state of the $\emptyset$ clock.   The specific configuration
of the I/O lines of ports A-C in the test mode will
now be given.   During $\emptyset2$ of the test mode, port A
becomes the input data bus and can be used to supply
instructions and data to CPU 100.   In the test mode,
SW 197 disconnects PDB 190 from CPU 100, so that all
data and instructions must be entered through
port A.

The eight I/O lines of port B are connected
to PDB 190 as usual during $\emptyset2$ of the test mode.
During $\overline{\emptyset2}$ of the test mode, lines b0-b7 of port B
become address lines AB0-5, 9 and 10.   Also during
$\overline{\emptyset2}$ of test mode, lines c0-c3 of port C become
address lines AB6-8 and the R/W line.   As a conse-
quence, during $\overline{\emptyset2}$ of the test mode RAM 110 and
ROM 120 may be accessed externally.

The TIMER input is an external input to
the on-chip timer counter 131 (FIG. 1).   The timer
counter 131 is an 8-bit timer that is initialized
by software and counts down towards zero.   If the
timer interrupt is enabled (i.e. the timer interrupt
mask bit 6 is clear and the I bit in the CCR is also
clear), an interrupt will occur when the timer counter 131 reaches zero.   At this time, the timer interrupt request bit 7 is set in the timer control register 130.   The microcomputer hardware responds to the timer interrupt request by saving the machine state on the stack and then fetching an address (2 bytes) from the timer interrupt vector (locations S7F8 and S7F9).   Once in the service routine it is necessary for the software to reset the timer interrupt request bit 7 in timer control register 130. The timer counter 131 continues to count after reaching zero so that the software can determine the length of time since the interrupt by reading the timer counter 131.   Reading of the timer control register 130 takes place without disturbing the countdown operation.   Should a timer interrupt and an external interrupt (INT) occur simultaneously, the INT has priority over the time.   The timer interrupt request bit 7 will remain set until reset by software. After the INT interrupt routine returns, the timer interrupt may then be processed.

The prescaler 132 extends the maximum timing interval of the timer counter 131.   Since prescaler 132 is not readable or writable as is the timer

-17-

counter 131, a low-end n-bit truncation error exists in using the prescaler 132. At power-up/reset time, the timer interrupt request bit 7 of timer counter 131 is cleared and the timer interrupt mask bit 6 is set. The timer counter 131 and prescaler 132 are also initialized to all ones.

The TIMER input when subjected to a voltage of greater than 8 volts (design) utilises a differential amplifier to sense the overvoltage (timer usually runs at +5 volts) and generate a signal. This puts the device in the self-test mode which is the subject of the present invention. The operation of a differential amplifier suitable for this application is set forth in application Serial No. (SC-79638), by James Thomas filed on even date herewith and assigned to the assignee of the instant invention.

Also shown in FIG. 3, connected to the microcomputer 200 are a plurality of light-emitting diodes 202, 204, 206, 208 and serially connected with each LED is a resistor 210, 212, 214, 216 the other side of which is connected to a source of potential.

The TEST pin is connected to ground in the Self-Test mode of operation. As noted above the

-18-

TEST pin is used to alter the internal bus organization such that the internal operation of the microcomputer is controllable through the I/O ports.   This Test mode is not related to Self-Test Mode as will be hereafter described.

The KTL and DKTL pins are connected together and RESET is connected to a simple R-C network as described above.

As previously noted. Port A and Port B are I/O ports wherein each line is individually programmable to be either an input or an output pin.   In Self-Test Mode, line A0 is connected to line A4, A1 to A5, A2 to A6 and A3 to A7.   Similarly, Port B is connected: B0-B4, B1-B5, B2-B6, B3-B7.   These connections are made in this manner to allow I/O tests as will be further described.   A6 is additionally connected to INT, to provide an interrupt test as will be discussed.

## Interrupts

The microcomputer shown in FIG. 1 has two hardware interrupts and one software interrupt.   When an interrupt occurs, normal processing is suspended and an interrupt routine is executed.

One hardware interrupt is the timer interrupt. If the timer mask bit in the timer control word is zero, each time the timer counter 131 reaches zero it will generate an interrupt if the interrupt mask bit in the CCR is also zero. When the interrupt is recognized the current machine state is pushed onto the stack and PC is loaded with the address (two bytes) stored at memory location S7F8, and the I bit in the CCR is set to mask further interrupts. The address at S7F8 is the address of the timer interrupt routine. At the end of the execution of the timer interrupt routine on RTI instruction is executed which restores the machine state and returns to the interrupt program with all registers unchanged.

The external interrupt is the second hardware interrupt. If the I bit in the CCR is cleared (i.e. interrupts enabled) and the INT pin crosses zero on a negative edge, the INT interrupt will occur. Recognition of the INT is much the same as the timer interrupt except that the address of the external interrupt routine is stored at S7FA.

The software interrupt is an executable instruction that resembles the hardware interrupt.

-20-

When the SWI is executed the machine state is saved on the stack and the vector is fetched from S7FC. An SWI instruction will be executed regardless of the state of the I bit in the CCR. Software interrupts are useful as break points for debugging purposes.

Reset also resembles an interrupt. When reset occurs, the vector which is stored at S7FE is loaded into the program counter. During reset the I bit is set in the CCR, and the timer interrupt mask bit is set in the timer control register 130. Also, the stack pointer is set to S07F. In addition the timer counter 131 and prescaler 132 are set to all ones, and the data direction registers in the data direction logic 141, 151, and 161 are cleared for all I/O ports.

The stacking order occurring during interrupts is as shown in Fig. 6. Since the stack pointer decrements during a push operation, the PCL is stacked first, then the PCH, and so on. Pulling from the stack is in the reverse order. The stack pointer always points to the next free location on the stack.

Self-Test Mode Operation

To begin the Self-Test sequence, power is applied to the device ($V_{DD}$), and RESET is held low (reset mode).  A voltage greater than +8 volts (9 volts preferred) is applied to TIMER pin while RESET is still low and RESET is then released.  So long as the 9 volts remains on TIMER, the device will remain in Self-Test Mode.

Internally, the application of 9 volts to TIMER while RESET is low causes signal "RGD", through the logic shown in FIG. 4A) to go to a high state (RGD is low for normal operation).  The high voltage on the TIMER pin is detected by differential amplifier 300 which causes RGD.

Signal RGD initiates two operations to begin the Self-Test.  First, RGD is applied as an input to PCL 2 to force the prescaler to toggle on each machine cycle.  PCL 2 turns on a transistor 302. which allows the Ø2 clock to directly drive PCLK, the prescaler input (FIG. 4C).  As will be seen later, this will insure that the timer 131 will overflow (or underflow is preset and decremented) sometime during the Self-Test program execution, which allows the program to test both the timer and the timer interrupt for proper operation.

Second, as an input to gate ØA31 (FIG. 4B) a zero will appear on ABL 3 (ROM Address Bus Low, bit 3)

-22-

any time the RESET, SW1, or Interrupt Vectors addresses are fetched. Thus, while normally the device fetches vector address upon the occurrence of various events, RGD forces different vector addresses to direct the device to the ROM area wherein the Self-Test program is located.

The following shows the effect of changing ABL 3 from "1" to "0".

|  | | (Binary) | (HBX) |
|---|---|---|---|
| Normal Vector Addressed: | RST = | 111 1111 1110 | = 7FE |
|  | SWI = | 111 1111 1100 | = 7FC |
|  | INT = | 111 1111 1010 | = 7FA |
|  | TIMER = | 111 1111 1000 | = 7FB |
|  | | | |
| Vector Addresses in | RST = | 111 1111 0110 | = 7F6 |
| Self-Test: | SWI = | 111 1111 0100 | = 7F4 |
|  | INT = | 111 1111 0010 | = 7F2 |
|  | TIMER = | 111 1111 0000 | = 7F0 |

ABL3

The addresses at the vector locations are permanently programmed in the ROM when the individual device is manufactured. The normal vector addresses contain the starting addresses of programs that the user wishes the device to execute in response to RST, SWI, etc. The Self-Test vector addresses contain the addresses of the routines in the Self-Test program that test the various sections of the device (Logic, memory, I/O, etc.) and serve as a means for steering the device into the Self-Test program.

Once the Self-Test RST vector has been forced and the Self-Test program begins to run, it will continue testing, so long as no fault occurs and so long as TIMER remains at +9V, in an endless loop. After each major test is run some I/O lines on Port C are changed to show that a test was passed. If any test fails, the program hangs up by executing a "branch to self" instruction. The output lines will cease to change and two I/O lines will indicate the category of failure.

The Self-Test program (a listing is attached as Appendix A) runs the following tests:

| | | |
|---|---|---|
| Port C | - | Test Port C for good input |
| I/O | - | Test Ports A and B for good input and output |
| RAM | - | Test with walking bit memory test |
| ROM | - | Test open or short row or column and verify a prestored checksum |
| Interrupt | - | INT and Timer interrupts. |

-24-

CPU          -   Test numerous instructions
                 inherently by running Self-
                 Test program.

The Port C test is run only once after reset. The others are repeated as long as no errors are found.   The test status is available on Port C.   . After the Port C test, Port C is used as an output to indicate which test is running.   If any test fails, the output lines remain stable and the lower 2 bits of Port C indicate the test that failed.   Since there are only 4 "checkpoints" in the main loop, it is not possible to always determine exactly what is wrong with the part.   The probable errors if the test has stopped are as follows:

| 81 | BO | PROBLEM |
|----|----|---------|
| 0  | 0  | Interrupt Failure |
| 0  | 1  | Bad Port A or Port B |
| 1  | 0  | Bad RAM |
| 1  | 1  | Bad ROM |

The time required for one cycle of the program is approximately 80 milliseconds.   After each test, Port C is incremented.   Therefore, Bit 1 should appear to oscillate with a period of about 80 ms.

-25-

It may be difficult to discern this since the duty cycle on Bit 1 is not a square wave. Bit 2 and Bit 3 will however have square wave outputs. Bit 2's period will be twice as long as Bit 1, and Bit 3 should blink at about 3 Hz.

The LED's 202, 204, 206, 208 (FIG. 3) connected to Port C provide the visual indication.

The program begins at location 0784 (line number 01006A of the listing of Appendix A) and resides at memory locations S784-S7F7 in the ROM ("S" preceding a number indicates hexadecimal), and is 116 bytes long. The program first resets again (RSP) at 0734 and then compares the contents of Port C with SFF. FIG. 3 shows the four lines of Port C connected to a positive voltage level and when Port C is an input the four high levels on the port lines will compare positively with SFF if the port is properly functioning as an input. At S787 is a branch if Port C is not SFF. The branch is to S787, so the program will hang up at that point if Port C is not operative; and the test will go no further, as the LED 206 will not blink at a 3 Hz rate. A positive comparison at S787 sets Port C to zero and at S789 the Port C Data Direction Register

-26-

is set to configure Port C as an output for the remainder of the Self-Test program. It should be recalled that the Port C input test is performed only once, so subsequent iterations of the Self-Test program will begin at the ROM location S78B.

Location S78B is a clear instruction which is followed by a software interrupt (SWI) instruction, indicating that the first test (Port C input) was passed. The SWI instruction forces a vector S7F4 as previously noted, which contains an address S7E7, the beginning instruction of the software interrupt routine. The SWI routine consists of an incrementation of Port C and an RTE at S7E9 to return to the main Self-Test program at the exit point +1.

The main loop of the program now runs four tests, the first of which is a test of the remaining I/C lines (8 Port A and 8 Port B lines). The I/O pins are externally wired together as shown in FIG. 3. Bit lines D4-B7 are first set as output lines (by means of the Data Direction Register associated with each port) and bits B0-B3 as input lines. A nybble 1010 is outputted from lines B4-B7 and inputted on B0-B3. Subsequently the nybble values are reversed (0101) and the I/O operation repeated. This is accomplished by means of the subrouting beginning at S7DB.
The DDR is then reset to set B4-B7 as input and
B0-B3 as output, and the test is repeated. Port A
is next tested in a similar manner (the outputs in
each case being compared with expected inputs) and
if the test is passed an SWI occurs at S79C. Recall that SWI increments the latches of Port C and
returns to the main program.

The next test is the RAM test beginning at
S79D in which a "walking bit" pattern is written
into the memory and verified. Nine different
patterns are used which test the RAM by eventually
setting every bit to one and zero. As in the other
tests of this program, this particular test is a
preferred embodiment. Others, of course, may be
used, requiring more or less time and giving more
or less confidence in test result. The "branch to
self" in the event of a filed test is evident at
S7A8 which, as before, stops I/O acitivity and the
test, as the program hangs up at this point. Exemplary patterns are shown as follows:

```
        Pattern #1              Pattern #2              Pattern #8              Pattern #9
+-------------------+  +-------------------+   +-------------------+   +-------------------+
! 0 0 0 0 0 0 0 0 !  ! 1 0 0 0 0 0 0 0 !   ! 0 0 0 0 0 0 1 0 !   ! 0 0 0 0 0 0 0 1 !
+-------------------+  +-------------------+   +-------------------+   +-------------------+
! 1 0 0 0 0 0 0 0 !  ! 0 1 0 0 0 0 0 0 !   ! 0 0 0 0 0 0 1 1 !   ! 0 0 0 0 0 0 0 0 !
+-------------------+  +-------------------+   +-------------------+   +-------------------+
! 0 1 0 0 0 0 0 0 !  ! 0 0 1 0 0 0 0 0 !   ! 0 0 0 0 0 0 0 0 !   ! 1 0 0 0 0 0 0 0 !
+-------------------+  +-------------------+   +-------------------+   +-------------------+
! 0 0 1 0 0 0 0 0 !  ! 0 0 0 1 0 0 0 0 !   ! 1 0 0 0 0 0 0 0 !   ! 0 1 0 0 0 0 0 0 !
+-------------------+  +-------------------+   +-------------------+   +-------------------+
! 0 0 0 1 0 0 0 0 !  ! 0 0 0 0 1 0 0 0 !   ! 0 1 0 0 0 0 0 0 !   ! 0 0 1 0 0 0 0 0 !
+-------------------+  +-------------------+   +-------------------+   +-------------------+
!        o         !  !        o         !  o o!        o         !   !        o         !
!        o         !  !        o         !   !        o         !   !        o         !
!        o         !  !        o         !   !        o         !   !        o         !
!        o         !  !        o         !   !        o         !   !        o         !
+-------------------+  +-------------------+   +-------------------+   +-------------------+
! 0 0 0 0 0 0 1 0 !  ! 0 0 0 0 0 0 0 1 !   ! 0 0 0 0 1 0 0 0 !   ! 0 0 0 0 0 1 0 0 !
+-------------------+  +-------------------+   +-------------------+   +-------------------+
! 0 0 0 0 0 0 0 1 !  ! 0 0 0 0 0 0 0 0 !   ! 0 0 0 0 0 1 0 0 !   ! 0 0 0 0 0 0 1 0 !
+-------------------+  +-------------------+   +-------------------+   +-------------------+
! 0 0 0 0 0 0 0 0 !  ! 1 0 0 0 0 0 0 0 !   ! 0 0 0 0 0 0 1 0 !   ! 0 0 0 0 0 0 0 1 !
+-------------------+  +-------------------+   +-------------------+   +-------------------+
```

Following the RAM test, at S7B1, an SWI indicates the passed test, increments Port C and returns to S7B2 to execute the ROM test. The ROM test performs an "exclusive OR" of all bytes of ROM (including a user program and a prestored checksum byte stored at S7EF) which should produce a result of SFF (1's parity). The checksum is chosen to force this result if the ROM itself is good. The checksum is placed in the ROM together with the Self-Test program. This test detects address and/or data lines stuck high, low or to each other. By careful placement of the program in ROM, open or shorted rows and columns can also be detected. Bad decoders would, of course, also be detected. The test program optimally would be placed so as to utilize the end of each row and each column of the ROM. Row/column shorts and opens are also detected. This test is useful because zome ROM faults are possible where the test program will still run.

Locations S7B2-S706 contain the ROM test instructions. In many cases, unusual instructions may be utilized resulting in seemingly inefficient or confusing software structure. The instructions were chosen to maximally exercise the instruction set capability of the device in an otherwise brief and simple test sequence.

Location S7C8 is the SWI which increments Port C and returns to S7C9. In the interim, while the prior tests have been executing, the timer which was counting at $\emptyset$2 clock speed has had an opportunity to overflow. An overflow of the timer, of course, causes an interrupt as noted above - in the section "Interrupts". The I/O test previously noted, as conducted on Port A, causes an external interrupt INT

0018736

-30-

since the AO line of Port A is coupled to INT.
When AO goes low during the test, the INT latch
is set.

The processing of each of these interrupts
provides a further test.  Both INT and timer inter-
rups are maskable and, for purposes of running Self-
Test, both have been masked.  Both also, however,
set latches upon occurrence.  When, at S7C9 the
mask of the INT interrupt is removed, the INT
alternate vector subroutine is entered at S7BC and
has the effect of performing an ASR (Arithmetic
Shift Right) at RAM memory location S4B which was
initialized at 1000 0000 by the RAM test.  Following
execution of INT, the contents of S4B would be
0100 0000.  A return to program is made and the
timer overflow interrupt is serviced by jumping to
S7BA which cleans the timer interrupt flag, followed
by another ASR.  The resultant S4B value is 0010 000.
After the timer interrupt is completed, control is
returned to location S7D5.

Location S7D5 is a BRCLR totest whether bit 5
(beginning always with bit 0) is clear.  If clear
(not present) the branch is to S7D5 or "branch to
self".  If "not clear" the program fails to location S7D8 which begins execution of the Self-Test program again at location S76B.

The SWI instructions which each increment Port C cause bit 3 of Port C to blink at approximately 3 Hz.

As noted above, if this test is performed at an early stage, i.e. wafer probe, a number of . devices can be eliminated from further processing (assembly) and test without the use of expensive test equipment.

Further, after shipment of devices to customers, the customers have the ability to perform a test with a reasonably high degree of certainty and little time and expense. The blinking of the Port C I/O line provides a simple test, easily observable, and readily understood. As previously noted, if the "blinking" test fails, the sequence of SWI's cause the Port C to hand up in a state which should broadly indicate the failure mode.

While the invention has been described in a preferred embodiment it will be apparent to those skilled in the art that the disclosed invention may be modified in numerous ways and may assume many embodiments other than that specifically set out

-32-

and described above.    Accordingly, it is intended
by the appended claims to cover all modifications
of the invention which falls within the true spirit
and scope of the invention.

```
00995                    *       EQUATES
00996                    *
00997        0000      A ANY     EQU    0          RANDOM BIT IN A BYTE
00998                    *
00999        0040      A RAM     EQU    $40        START OF ON-CHIP RAM
01000        0040      A RAMSUB  EQU    $40        START OF BUILT SUBROUTINE
01001        004B      A LOC     EQU    RAMSUB+11  LOC IS $80 AFTER RAM TEST
01002        007C      A STACKA  EQU    $7C        ACCA WHEN STACKED BY INTERRUPT
01003        007D      A STACKX  EQU    $7D        ACCX THE SAME
01004                    *
01005                    *
01006A 0784                      ORG    MEMSIZ-116-8
01007                    *
01008                    *       BEGIN OF SELF TEST
01009                    *
01010A 0784            START     RSP               RESET JUST IN CASE
01011A 0785 33 02    A           COM    PORTC      SHOULD HAVE READ $FF
01012A 0787 26 FE  0787          BNE    *          PORTC BAD ON INPUT
01013                    *       COM SET PORTC TO ZERO
01014A 0789 10 06    A           BSET   ANY,PORTC+DDR AND PROGRAM DATA DIRECTION
01015                    *
01016                    *       MAIN LOOP (REPEATED)
01017                    *
01018A 078B 3F 09    A LOOP      CLR    TIMER+1    RESET TIMER INTERRUPTS
01019                    *
```

```
01020A 078D 83                    SWI          PASSED FIRST TEST
01021                   *
01022                   *         INPUT/OUTPUT PORT TESTS
01023                   *
01024A 078E AE 01        A IOTST  LDX      #PORTB    POINT TO PORTB FIRST
01025A 0790 A6 F0        A IOTST2 LDA      #$F0
01026A 0792 AD 47   07DB          BSR      IOSUB     RETURNS WITH A=$54
01027A 0794 A9 BA        A        ADC      #$0F-$54-1 A IS SET TO $0F
01028A 0796 AD 43   07DB          BSR      IOSUB     AGAIN WITH NYBBLES REVERSED
01029A 0798 5A                    DECX
01030A 0799 27 F5   0790          BEQ      IOTST2    AGAIN FOR PORTA
01031A 079B 4F                    CLRA               CLEAR A FOR NEXT TEST
01032                   *
01033A 079C 83                    SWI                PASSED I/O TEST
01034                   *
01035                   *         RAM TEST
01036                   *
01037                   *         ENTER WITH C=1, A=0
01038                   *
01039                   *         EVERY BIT IN RAM IS GUARANTEED
01040                   *         TO HAVE BEEN SET TO ONE AND ZERO
01041                   *         AND HAVE BEEN TESTED FOR CORRECT
01042                   *         DATA.
01043                   *         NOTE THAT RESULTS OF THE RAM TEST
01044                   *         ARE USED IN SUBSEQUENT TESTS (ROM AND
```

```
01045                      *      INTERRUPTS).
01046                      *
01047                      *      PATTERN IS IN A AND C
01048A 079D AE 40      A GEN     LDX    #RAM
01049A 079F F7           GEN2    STA    ,X        GENERATE PATTERN
01050A 07A0 46                   RORA
01051A 07A1 5C                   INCX
01052A 07A2 2A FB  079F          BPL    GEN2      MEMORY FILLED WHEN X=$80
01053A 07A4 49                   ROLA             RETURN TO INITIAL SEED
01054A 07A5 AE 40      A         LDX    #RAM
01055A 07A7 F8           VERIFY  EOR    ,X        LOOK FOR BIT DIFFERENCES
01056A 07A8 26 FE  07A8          BNE    *         HANG HERE FOR BAD MEMORY
01057A 07AA F6                   LDA    ,X        RESTORE SEED FROM MEMORY
01058A 07AB 46                   RORA             NEXT COMPARE VALUE
01059A 07AC 5C                   INCX
01060A 07AD 2A F8  07A7          BPL    VERIFY    CONTINUE VERIFICATION
01061A 07AF 24 EC  079D          BCC    GEN       PERFORM TEST A TOTAL OF 9 TIMES
01062                      *
01063A 07B1 83                   SWI              PASSED RAM TEST
01064                      *
01065                      *      ROM TEST
01066                      *
01067                      *      ENTER WITH: RAMSUB+1=$00
01068                      *                  RAMSUB+2=$80
01069                      *                  RAMSUB+3=$40
```

```
01070       *              A=0
01071       *              C=1
01072       *
01073       *  THE ROM TEST PERFORMS AN EXCLUSIVE
01074       *  OR OF ALL BYTES OF ROM WHICH SHOULD
01075       *  PRODUCE A RESULT OF $FF (1'S PARITY).
01076       *  THE CHECKSUM HAS BEEN CHOSEN TO FORCE
01077       *  THIS RESULT IF THE ROM ITSELF IS
01078       *  GOOD.  ADDRESS AND DATA LINES STUCK HIGH,
01079       *  LOW OR TO EACH OTHER ARE
01080       *  DETECTED WITH HIGH PROBABILITY.
01081       *
01082       *  FOR A DISCUSSION OF THE RELIABILITY OF
01083       *  THIS METHOD OF TESTING THE ROM, SEE
01084       *  "MICROPROCESSOR BASED DESIGN" BY DR. J. B.
01085       *  PEATMAN, PAGES 315-316.
01086       *
01087A 07B2 AE C8      A ROMTST LDX    #$C8      =EOR EXTENDED
01088A 07B4 BF 40      A        STX    RAMSUB
01089A 07B6 39 43      A        ROL    RAMSUB+3 =RETURN FROM SUBROUTINE
01090A 07B8 BD 40      A SUM    JSR    RAMSUB
01091A 07BA 3C 42      A        INC    RAMSUB+2 ADVANCE TO NEXT ADDRESS
01092A 07BC 22 FA   07B8        BHI    SUM
01093A 07BE 3C 41      A        INC    RAMSUB+1
01094A 07C0 07 41 F5 07B8       BRCLR  3,RAMSUB+1,SUM LOOK FOR $8 IN RAMSUB+1
```

```
01095A 07C3 40              NEGA            A SHOULD HAVE BEEN $FF,
01096A 07C4 A2 00      A    SBC    #0       DECREMENT A TO ZERO
01097A 07C6 26 FE     07C6  BNE    *        HANG HERE FOR BAD ROM
01098                  *
01099A 07C8 83              SWI             PASSED ROM TEST
01100                  *
01101                  *    INTERRUPTS TEST
01102                  *
01103                  *    ENTER WITH: X=$C8
01104                  *                A=$0
01105                  *                LOC=$80
01106                  *
01107                  *
01108                  *    INTERRUPT TEST ALLOWS INTERRUPTS
01109                  *    LONG ENOUGH TO GET ONE TIMER
01110                  *    INTERRUPT AND ONE INT INTERRUPT.
01111                  *    THE INTERRUPT SERVICE ROUTINES
01112                  *    SHIFT A BYTE IN MEMORY TO A KNOWN
01113                  *    PATTERN WHICH IS CHECKED AFTER
01114                  *    THE INTERRUPTS SHOULD HAVE OCCURED.
01115                  *    FURTHER, THE A AND X REGISTER ARE
01116                  *    COMPARED WITH WHAT WAS STACKED DURING
01117                  *    THE INTERRUPTS.
01118                  *
01119                  *    A TIMER INTERRUPT IS GUARANTEED PENDING
```

```
                                *    BY ALLOWING ENOUGH TIME TO ELAPSE
                                *    DURING THE OTHER TESTS TO UNDERFLOW THE
                                *    COUNTER (EVEN WITH MAXIMUM PRE-SCALE).
                                *    THE INT INTERRUPT IS ALSO GUARANTEED
                                *    SINCE THE INT LINE IS TIED TO THE PORTA
                                *    LINE WHICH WIGGLES UP AND DOWN DURING THE
                                *    I/O TEST.
                                *
A 07C9 9A                INTTST CLI              ALLOW INT AND TIMER INTERRUPT
A 07CA 9B                       SEI              INTERRUPTS SHOULD BE DONE NOW
A 07CB 2C FE      07CB          BMC    *         I-BIT NOT WORKING
A 07CD B0 7C         A          SUB    STACKA    COMPARE A WITH STACKED VALUE
A 07CF 26 FE      07CF          BNE    *         INTERRUPT FAILED
A 07D1 B3 7D         A          CPX    STACKX    ALSO CHECK X
A 07D3 26 FE      07D3          BNE    *
A 07D5 0B 4B FD 07D5            BRCLR  5,LOC,*   BIT SHOULD SHIFT HERE
                        *
                        *    END OF TESTS
                        *
                        *    NOTE THE USE OF A 2-BYTE INDEXED JUMP
                        *    WHICH FORCES A CARRY FROM THE LOWER BYTE
                        *    IN COMPUTING THE JUMP ADDRESS.
                        *
A 07D8 DC 06C3      A           JMP    LOOP-$C8,X DO IT AGAIN
                        *
```

```
                              *
                              *
                              *
                              *      I/O TEST SUBROUTINE
                              *
                              *      RETURNS WITH A=$54 and C=1
                              *
                              *      ENTERED WITH X POINTING TO THE PORT
                              *      TO TEST.
                              *
A 07DB E7 04       A IOSUB   STA    DDR,X        SETUP DATA DIRECTION
A 07DD A6 55       A         LDA    #$55         ALTERNATE 1'S AND 0'S
A 07DF F7            AGAIN   STA    ,X           SAVE IT AND SEE
A 07E0 F1                    CMP    ,X           IF IT STAYS THERE
A 07E1 26 FE       07E1      BNE    *            BAD I/O PORT(S)
A 07E3 48                    LSLA                SHIFT PATTERN TO $AA
A 07E4 2B F9       07DF      BMI    AGAIN        AND REPEAT TEST
A 07E6 81                    RTS
                              *
                              *
                              *      INTERRUPT ROUTINES
                              *
                              *      SOFTWARE INTERRUPT IS RESPONSIBLE FOR
                              *      ADVANCING THE VALUE STORED IN PORTC.
                              *
```

```
01170A 07E7 3C 02      A SOFT   INC    PORTC      ADVANCE TO NEXT TEST
01171A 07E9 80           RTI               AND EXIT
01172                  *
01173                  *      SOFTWARE, INT AND TIMER INTERRUPTS
01174                  *      SHIFT LOC ONE PLACE TO THE RIGHT
01175                  *
01176A 07EA 1F 09      A TIMEUP BCLR   7,TIMER+1 HANDLE INTERRUPT
01177A 07EC 37 4B     .A INTR   ASR    LOC        SHIFT FLAG AROUND
01178A 07EE 80           RTI
01179                  *
01180A 07EF    E9      A CHKSUM FCB    $E9        ROM CHECKSUM (ODD 1'S PARITY)
01181                  *
01182                  *
01183                  *      SELFTEST ALTERNATE INTERRUPT VECTORS
01184                  *
01185A 07F0    07EA    A         FDB    TIMEUP
01186A 07F2    07EC    A         FDB    INTR
01187A 07F4    07E7    A         FDB    SOFT
01188A 07F6    0784    A         FDB    START
01189                  *
01190          0784    A         END    START   WAZU
TOTAL ERRORS 00001--00693
**** UNDEFINED SYMBOLS
GAME
```

- 1 -

C L A I M S

1. In a microcomputer having a central processing unit (CPU) (100) for executing instructions, a read only memory (ROM) (120), a bus (190) connected to said CPU and said ROM for providing instructions stored in said ROM for execution by said CPU, a method for testing the functionality of said ROM comprising:

a) arranging a test program in said ROM at ends of rows and/or columns of said ROM and

b) executing at least one of said instructions.

2. The method as set forth in claim 1 wherein said microcomputer further comprises a plurality of input/output lines, and wherein the execution of said at least one of said instructions outputs data on an output line and senses data on an input line.

3. The method as set forth in claim 1 wherein said microcomputer further comprises means for accessing a user program stored in said ROM, and wherein in response to a signal accesses are alternatively made to said test program.

4. In a microcomputer having an instruction execution means (100), a read only memory (ROM) means (120), an input/output means (140,150,160), and a random access memory (RAM) means (110), a control program stored in said ROM for controlling the operation of the microcomputer to test the functionality of the RAM and input/output means, said control program being arranged in said ROM such that the successful execution of the control program acts to test the functionality of the ROM.

- 2 -

5. A microcomputer as set forth in claim 4 further comprising indicating means (202, 204, 206, 208) for indicating successful execution of said control program.

6. A microcomputer as set forth in claim 5 wherein said indicating means is activated by the occurrence of a series of interrupts each of which is responsive to completion of execution of segments of said control program.

7. A microcomputer as set forth in claim 6 wherein each of said segments of said control program provides a series of instructions for testing the functionality of one of said RAM, said input/output means and said ROM.

8. A microcomputer as set forth in claim 7 further comprising a timer means (131), and wherein at least one of said segments of said control program provides a series of instructions for testing the functionality of said timer means.

9. In an interrupt driven logic device having processing unit (100) for executing instructions and a memory (120) for storing instructions, said memory also storing addresses of instructions at vector locations which are automatically fetched upon the occurrence of an interrupt, a) means for applying a signal to said logic device, b) means for indicating an interrupt condition and for fetching a vector address in response thereto, and c) means responsive to said signal for fetching an alternate vector address when said signal is present.

Fig.II

Fig.2

D0-7 · DBO · DBI 45 46 47 · ALU 28 · A B · ACCA 24 · IXR 20 · TEMPL 17 · SW 3 · ABL1 4 · DB 6 · CCR 30 · DBE 23 · I/R 50 49 · 41 40 · 35 · SP 18 · TEMPH 16 · PCL 15 · PCH 14 · INCL 13 11 · 12 · ABL 2 · ABH · OBL 32 · OBH 31 · A0-7 · A8-10 · R/W 54 10

0018736

3/6

Fig.3

INT
RST
XTL
EXTL
TST

+9V

V_DD

216  208
214  206
212  204
210  202

PORTC

6
8
0
5

A_0

A_7

B_0

B_7

PORTA

PORTB

V_SS

200

FIG.4A | FIG.4C
FIG.4B

Fig.4

Fig.6

PCH
PCL

Fig.4A    4/6

Fig. 4B

5/6

0018736

0018736

Fig. 4c

0018736

European Patent Office

**EUROPEAN SEARCH REPORT**

Application number

EP ... 30 ...

| | **DOCUMENTS CONSIDERED TO BE RELEVANT** | | | **CLASSIFICATION OF THE APPLICATION (Int Cl. 3)** |
|---|---|---|---|---|
| Category | Citation of document with indication, where appropriate, of relevant passages | | Relevant to claim | |
| | US – A – 3 838 260 (NELSON) | 1–5 | | G 06 F 11/26 |
| | * Column 1, lines 51–54; column 2, lines 18–21; column 2, line 60 to column 3, line 62; column 10, lines 16–26; column 11, lines 41–43; column 12, lines 43–48; column 13, lines 64–65; column 14, line 47 to column 16, line 9; column 17, lines 24–34; column 17, lines 44–60; column 18, lines 10–13, 29–43 and 54–61; column 19, lines 3–9 * | | | |
| | US – A – 3 967 103 (CACHUELA) | 5–6 | | **TECHNICAL FIELDS SEARCHED (Int.Cl. 3)** |
| | * Column 1, line 1 to column 2, line 50; column 4, line 51 to column 5, line 19; the claims * | | | G 06 F 11/26<br>G 11 C 29/00 |
| | FR – A – 2 295 492 (HONEYWELL) | 1,7,8 | | |
| | * Page 2, line 15 to page 3, line 11; page 20, line 1 to page 22, line 29; page 60, line 35 to page 61, line 23 * | | | |
| | US – A – 4 024 386 (CAUDEL) | 1,9 | | |
| | * Column 2, lines 19–32; column 26, line 64 to column 28, line 17; the claims * | | | **CATEGORY OF CITED DOCUMENTS** |
| P | ELECTRONIC DESIGN, vol. 27, no. 18, September 1979 Let your next microcomputer check itself and cut down your testing overhead" pages 100–105<br><br>* Whole article * | 1–9 | | X: particularly relevant<br>A: technological background<br>O: non-written disclosure<br>P: intermediate document<br>T: theory or principle underlying the invention<br>E: conflicting application<br>D: document cited in the application<br>L: citation for other reasons |
| | ./.. | | | &: member of the same patent family, corresponding document |

The present search report has been drawn up for all claims

| Place of search | Date of completion of the search | Examiner |
|---|---|---|
| THE HAGUE | 23–07–1980 | GUIVOI |

EPO Form 1503.1  06.78

European Patent Office

**EUROPEAN SEARCH REPORT**

| Category | DOCUMENTS CONSIDERED TO BE RELEVANT | | CLASSIFICATION OF THE APPLICATION (Int Cl. ³) |
|---|---|---|---|
| | Citation of document with indication, where appropriate, of relevant passages | Relevant to claim | |
| | US – A – 3 343 141 (HACKL)<br><br>* Column 14, line 56 to column 20, line 32 * | 1,4 | |
| | | | **TECHNICAL FIELDS SEARCHED (Int. Cl. ³)** |